# EUROPEAN PATENT SPECIFICATION

(11) **EP 3 514 615 B1**
(45) Date of publication and mention of the grant of the patent: **28.12.2022**
(21) Application number: 19153352.0
(22) Date of filing: 23.01.2019
(51) Int. Cl.: G02F 1/017, G02F 1/1335, C09K 9/00, C09K 11/02, C09K 11/08, C09K 11/89, G02B 5/02, G02B 5/20, G02B 5/22, G03F 7/028, G03F 7/032, H01L 27/32, H01L 33/50, G03F 7/00, B82Y 20/00, B82Y 30/00, B82Y 40/00

(54) **PHOTORESIST RESIN COMPOSITION, FILM PREPARED THEREFROM, COLOR CONVERSION ELEMENT INCLUDING THE FILM, AND ELECTRONIC DEVICE INCLUDING THE COLOR CONVERSION ELEMENT**
FOTOLACKHARZZUSAMMENSETZUNG, DARAUS HERGESTELLTER FILM, FARBUMWANDLUNGSELEMENT MIT DEM FILM UND ELEKTRONISCHE VORRICHTUNG MIT DEM FARBWANDLUNGSELEMENT
COMPOSITION DE RÉSINE PHOTOSENSIBLE, FILM PRÉPARÉ À PARTIR DE CELLE-CI, ÉLÉMENT DE CONVERSION DE COULEUR COMPRENANT LE FILM ET DISPOSITIF ÉLECTRONIQUE COMPRENANT L'ÉLÉMENT DE CONVERSION DE COULEUR

(30) Priority: 23.01.2018 KR 20180008410
(43) Date of publication of application: 24.07.2019
(73) Proprietor: Samsung Display Co., Ltd, Gyeonggi-do (KR)
(72) Inventor: PARK, Kyoungwon, Gyeonggi-do (KR); KIM, Songyi, Gyeonggi-do (KR); NAM, Minki, Gyeonggi-do (KR); KIM, Sujin, Gyeonggi-do (KR); KIM, Jinwon, Gyeonggi-do (KR); KIM, Taeho, Gyeonggi-do (KR)
(74) Representative: Marks & Clerk LLP

(56) References cited:
- EP-A1- 3 147 708
- US-A1- 2017 183 565

## Description

### BACKGROUND

### FIELD

Embodiments of the invention relate generally to a photoresist resin composition, a film prepared therefrom, a color conversion element including the film, and an electronic apparatus including the color conversion element.

### DISCU SSION OF THE BACKGROUND

Liquid crystal display (LCD) apparatuses are flat-panel display apparatuses currently used in a wide range of applications. An LCD apparatus includes electric field-creating electrodes (e.g., a pixel electrode and a common electrode) disposed on a pair of display plates with a liquid crystal layer interposed between the pair of plates. An LCD apparatus displays an image by creating an electric field in a liquid crystal layer via application of voltage to electric field-creating electrodes, aligning an orientation of liquid crystal molecules of the liquid crystal layer, and thereby controlling polarization of incident light.

An LCD apparatus includes a color conversion element to realize colors, but a luminescent efficiency of the color conversion element is low since intensity of light emitted from a backlight light source decreases by about 1/3 while passing through a red color filter, a green color filter, and a blue color filter.

Thus, photo-luminescent liquid crystal display (PL-LCD) apparatuses, in which a quantum dot color conversion layer (QD-CCL) replaces a color conversion element in a conventional LCD apparatus, have been developed to prevent such a decrease in luminescent efficiency and improve color reproducibility. A PL-LCD apparatus displays a color image by using visible light generated by a light source that generates a lower wavelength light, such as ultraviolet light or blue light, which is adjusted by a liquid crystal layer and applied to a color conversion layer (CCL).

The above information disclosed in this Background section is only for understanding of the background of the inventive concepts, and, therefore, it may contain information that does not constitute prior art.

US 2017/183565 A1 discloses a quantum dot-polymer composite including a polymer matrix. EP 3147708 A1 discloses a photosensitive composition including a quantum dot dispersion, a photopolymerizable monomer having a carbon-carbon double bond, and a photoinitiator.

### SUMMARY

One or more embodiments include a photoresist resin composition, a film prepared therefrom, a color conversion element having improved color reproducibility and luminescent efficiency and an electronic apparatus including the color conversion element.

Additional aspects will be set forth in part in the description which follows and, in part, will be apparent from the description, or may be learned by practice of the presented exemplary embodiments.

According to one or more embodiments, there is provided a photoresist resin composition including: a plurality of quantum dots; a photopolymerizable monomer; a photopolymerization initiator; a scatterer; binder resin; and a solvent, wherein an amount of the scatterer is in a range of about 2 parts to about 20 parts by weight based on 100 parts by weight of the photoresist resin composition, and wherein the photoresist resin composition comprises the quantum dots and the scatterer at a weight ratio in a range of about 2:1 to about 10:1.

According to one or more embodiments, there is provided a film prepared by performing a heat treatment on the photoresist resin composition.

According to one or more embodiments, there is provided a color conversion element including the film.

According to one or more embodiments, there is provided an electronic apparatus including the color conversion element and a display apparatus.

The scope of the claimed invention is defined in the claims.

Additional features of the inventive concepts will be set forth in the description which follows, and in part will be apparent from the description, or may be learned by practice of the inventive concepts.

It is to be understood that both the foregoing general description and the following detailed description are explanatory and are intended to provide further explanation of the invention as claimed.

### BRIEF DESCRIPTION OF THE DRAWINGS

The accompanying drawings, which are included to provide a further understanding of the invention and are incorporated in and constitute a part of this specification, illustrate embodiments of the invention, and together with the description serve to explain the inventive concepts.
FIG. 1 is a schematic diagram of a structure of a color conversion element according to an embodiment.
FIG. 2 is a schematic diagram of a structure of a color conversion element according to another embodiment.
FIG. 3 is a schematic diagram of an electronic apparatus according to an embodiment.
FIG. 4 is a schematic diagram of an electronic apparatus according to another embodiment.
FIG. 5 is a schematic diagram of an electronic apparatus according to another embodiment.
FIG. 6 is a graph showing light absorption efficiency of quantum dots according to Examples 1 to 9.
FIG. 7 is a graph showing light conversion efficiency of a quantum dot photoresist film in a dependent manner with a refractive index of a quantum dot photoresist film formed by using the photoresist resin composition.
FIG. 8 is graph showing a change in a refraction index depending on an amount of a high-refractive material (refraction index=2.8) in a photoresist resin composition.

### DETAILED DESCRIPTION

In the following description, for the purposes of explanation, numerous specific details are set forth in order to provide a thorough understanding of various embodiments of the invention. It is apparent, however, that various embodiments may be practiced without these specific details or with one or more equivalent arrangements. In other instances, well-known structures and devices are shown in block diagram form in order to avoid unnecessarily obscuring various embodiments. Further, various embodiments may be different, but do not have to be exclusive. For example, specific shapes, configurations, and characteristics of an embodiment may be used or implemented in another embodiment without departing from the inventive concepts.

Unless otherwise specified, the illustrated embodiments are to be understood as providing features of varying detail of some ways in which the inventive concepts may be implemented in practice. Therefore, unless otherwise specified, the features, components, modules, layers, films, panels, regions, and/or aspects, etc. (hereinafter individually or collectively referred to as "elements"), of the various embodiments may be otherwise combined, separated, interchanged, and/or rearranged without departing from the inventive concepts.

The use of cross-hatching and/or shading in the accompanying drawings is generally provided to clarify boundaries between adjacent elements. As such, neither the presence nor the absence of cross-hatching or shading conveys or indicates any preference or requirement for particular materials, material properties, dimensions, proportions, commonalities between illustrated elements, and/or any other characteristic, attribute, property, etc., of the elements, unless specified. Further, in the accompanying drawings, the size and relative sizes of elements may be exaggerated for clarity and/or descriptive purposes. When an embodiment may be implemented differently, a specific process order may be performed differently from the described order. For example, two consecutively described processes may be performed substantially at the same time or performed in an order opposite to the described order. Also, like reference numerals denote like elements.

When an element, such as a layer, is referred to as being "on," "connected to," or "coupled to" another element or layer, it may be directly on, connected to, or coupled to the other element or layer or intervening elements or layers may be present. When, however, an element or layer is referred to as being "directly on," "directly connected to," or "directly coupled to" another element or layer, there are no intervening elements or layers present. To this end, the term "connected" may refer to physical, electrical, and/or fluid connection, with or without intervening elements. For the purposes of this disclosure, "at least one of X, Y, and Z," "at least one selected from the group consisting of X, Y, and Z," and "at least one element selected from the group consisting of X, Y, and Z" may be construed as X only, Y only, Z only, or any combination of two or more of X, Y, and Z, such as, for instance, XYZ, XYY, YZ, and ZZ. As used herein, the term "and/or" includes any and all combinations of one or more of the associated listed items.

Although the terms "first," "second," etc. may be used herein to describe various types of elements, these elements should not be limited by these terms. These terms are used to distinguish one element from another element. Thus, a first element discussed below could be termed a second element without departing from the teachings of the disclosure.

Spatially relative terms, such as "beneath," "below," "under," "lower," "above," "upper," "over," "higher," "side" (e.g., as in "sidewall"), and the like, may be used herein for descriptive purposes, and, thereby, to describe one elements relationship to another element(s) as illustrated in the drawings. Spatially relative terms are intended to encompass different orientations of an apparatus in use, operation, and/or manufacture in addition to the orientation depicted in the drawings. For example, if the apparatus in the drawings is turned over, elements described as "below" or "beneath" other elements or features would then be oriented "above" the other elements or features. Thus, the term "below" can encompass both an orientation of above and below. Furthermore, the apparatus may be otherwise oriented (e.g., rotated 90 degrees or at other orientations), and, as such, the spatially relative descriptors used herein interpreted accordingly.

The terminology used herein is for the purpose of describing particular embodiments and is not intended to be limiting. As used herein, the singular forms, "a," "an," and "the" are intended to include the plural forms as well, unless the context clearly indicates otherwise. Moreover, the terms "comprises," "comprising," "includes," and/or "including," when used in this specification, specify the presence of stated features, integers, steps, operations, elements, components, and/or groups thereof, but do not preclude the presence or addition of one or more other features, integers, steps, operations, elements, components, and/or groups thereof. It is also noted that, as used herein, the terms "substantially," "about," and other similar terms, are used as terms of approximation and not as terms of degree, and, as such, are utilized to account for inherent deviations in measured, calculated, and/or provided values that would be recognized by one of ordinary skill in the art.

Hereinafter, a photoresist resin composition according to an embodiment will be described.

### Photoresist resin composition

A photoresist resin composition according to an embodiment includes a plurality of quantum dots, a photopolymerizable monomer, a photopolymerization initiator, a scatterer, a binder resin, and a solvent.

An amount of the scatterer is in a range of about 2 parts to about 20 parts by weight based on 100 parts by weight of the total amount of the photoresist resin composition. For example, an amount of the scatterer is in a range of about 3 parts to about 20 parts by weight based on 100 parts by weight of the total amount of the photoresist resin composition. For example, an amount of the scatterer is in a range of about 4 parts to about 20 parts by weight based on 100 parts by weight of the total amount of the photoresist resin composition. For example, an amount of the scatterer is in a range of about 5 parts to about 20 parts by weight based on 100 parts by weight of the total amount of the photoresist resin composition. For example, an amount of the scatterer is in a range of about 5 parts to about 19 parts by weight based on 100 parts by weight of the total amount of the photoresist resin composition. For example, an amount of the scatterer is in a range of about 5 parts to about 18 parts by weight based on 100 parts by weight of the total amount of the photoresist resin composition. For example, an amount of the scatterer is in a range of about 5 parts to about 17 parts by weight based on 100 parts by weight of the total amount of the photoresist resin composition. For example, an amount of the scatterer is in a range of about 6 parts to about 17 parts by weight based on 100 parts by weight of the total amount of the photoresist resin composition.

When the amount of the scatterer is within the range above, due to the increase of front-light conversion rate with the increase of blue light absorption rate, a synergistic effect of the light conversion and/or luminance may be expected.

According to an embodiment, the scatterer is a light-scattering particle capable of reflecting light. The light-scattering particle may be selected from an inorganic particle, an organic resin particle, and a composite of an organic particle and an inorganic particle.

According to an embodiment, the scatterer may include a plurality of inorganic particles having different particle diameters from each other. For example, the scatterer may include two or more kinds of inorganic particles having different particle diameters from each other.

According to an embodiment, the plurality of the inorganic particles may include a first inorganic particle and a second inorganic particle, wherein a particle diameter of the first inorganic particle may be greater than that of the second inorganic particle. Here, the first inorganic particle may be referred to as a large-particle-sized particle, and the second particle may be referred to as a small-particle-sized particle.

As the photoresist resin composition includes a large-particle-sized scatterer, an effect of increasing a scattering effect and a refractive index may be obtained. Meanwhile, as the photoresist resin composition includes a small-particle-sized scatterer, an additional effect of increasing a refractive index may be obtained.

According to an embodiment, the particle diameter of the inorganic particle may be greater than 20 nm and less than 2 µm. For example, the particle diameter of the inorganic particle may be greater than 20 nm and 1.5 µm or less. For example, the particle diameter of the inorganic particle may be greater than 20 nm and 1 µm or less. For example, the particle diameter of the inorganic particle may be greater than 20 nm and 900 nm or less. For example, the particle diameter of the inorganic particle may be greater than 20 nm and 800 nm or less. For example, the particle diameter of the inorganic particle may be greater than 20 nm and 700 nm or less. For example, the particle diameter of the inorganic particle may be greater than 20 nm and 600 nm or less. For example, the particle diameter of the inorganic particle may be greater than 20 nm and 500 nm or less. For example, the particle diameter of the inorganic particle may be greater than 20 nm and 400 nm or less. For example, the particle diameter of the inorganic particle may be greater than 20 nm and 300 nm or less. For example, the particle diameter of the inorganic particle may be 30 nm or greater and 300 nm or less. For example, the particle diameter of the inorganic particle may be 40 nm or greater and 300 nm or less. For example, the particle diameter of the inorganic particle may be 50 nm or greater and 300 nm or less. For example, the particle diameter of the inorganic particle may be 60 nm or greater and 300 nm or less. For example, the particle diameter of the inorganic particle may be 70 nm or greater and 300 nm or less. For example, the particle diameter of the inorganic particle may be 80 nm or greater and 300 nm or less. For example, the particle diameter of the inorganic particle may be 90 nm or greater and 300 nm or less. For example, the particle diameter of the inorganic particle may be 100 nm or greater and 300 nm or less. For example, the particle diameter of the inorganic particle may be 100 nm or greater and 400 nm or less. For example, the particle diameter of the inorganic particle may be 100 nm or greater and 500 nm or less. For example, the particle diameter of the inorganic particle may be 100 nm or greater and 600 nm or less. For example, the particle diameter of the inorganic particle may be 100 nm or greater and 700 nm or less. For example, the particle diameter of the inorganic particle may be 100 nm or greater and 800 nm or less. For example, the particle diameter of the inorganic particle may be 100 nm or greater and 900 nm or less. For example, the particle diameter of the inorganic particle may be 100 nm or greater and 1 µm or less. The particle diameter can be measured from the TEM image.

When the particle diameter of the scatterer is too small, the scattering effect is small so that the amount of scattered light absorbed by the quantum dots is reduced, resulting in a failure of improvement of sufficient light conversion efficiency. Meanwhile, when the particle diameter of the scatterer is too large, the scattering effect is great so that the incident light is hardly emitted to the outside, resulting in a decrease in luminance. Therefore, when the particle diameter of the scatterer is within the range above, there is an improvement in light conversion efficiency.

When the scatterer has a particle diameter within the range above (e.g., greater than 20 nm and less than 2 µm) and the large-particle-sized scatter and the small-particle-sized scatter that have a different particle diameter from each other, are used together, a refractive index difference between a resin upper film and a resin lower film may be caused by the effect of increasing the refractive index by the small-particle-sized scatterer. Consequently, blue light may be totally reflected into the resin, thereby enabling recycling blue light. Accordingly, the absorption rate of blue light and the light conversion rate also increase.

According to an embodiment, the scatterer may include an inorganic particle having a refractive index of greater than 1.5. When the scatterer has a refractive index exceeding 1.5, sufficient scattering may be obtained.

For example, the scatterer may have a refractive index of 1.8 or greater. For example, the scatterer may have a refractive index of 2.0 or greater. For example, the scatterer may have a refractive index of 2.1 or greater. For example, the scatterer may have a refractive index of 2.2 or greater. For example, the scatterer may have a refractive index of 2.3 or greater. For example, the scatterer may have a refractive index of 2.4 or greater. For example, the scatterer may have a refractive index of 2.5 or greater. For example, the scatterer may have a refractive index of 2.6 or greater. For example, the scatterer may have a refractive index of 2.7 or greater. For example, the scatterer may have a refractive index of 4.0 or less.

When the scatterer has a refractive index of greater than 1.5, due to a difference with a resin refractive index of 1.5, an excellent scattering effect may be obtained.

The scatterer may be an inorganic particle having an above-described particle diameter described and an above-described refractive index. For example, the scatterer may be an inorganic particle having a refractive index of greater than 1.5 and a particle diameter in a range of about 100 nm to about 300 nm. The particle diameter can be measured from the TEM photograph.

According to an embodiment, the scatterer may include an inorganic oxide particle, an organic particle, or any combination thereof.

According to an embodiment, the scatterer may include BiFeO₃, Fe₂O₃, WO₃, TiO₂, SiC, BaTiO₃, ZnO, ZrO₂, ZrO, Ta₂O₅, MoO₃, TeO₂, Nb₂O₅, Fe₃O₄, V₂O₅, Cu₂O, BP, Al₂O₃, In₂O₃, SnO₂, Sb₂O₃, ITO, or any combination thereof.

For example, the scatterer may include TiO₂. For example, the scatterer consists of TiO₂.

According to an embodiment, the photoresist resin composition includes a plurality of quantum dots.

The quantum dots may each be a particle with several to several ten-nanometer sizes and formed of several hundreds to several thousands of atoms.

Due to the very small particle sizes, quantum confinement effect may be observed in the quantum dots. The term "quantum confinement effect" refers to a phenomenon in which a band gap of an object increases as a size of the object decreases to a nanometer or less. Thus, when light having a wavelength with an energy greater than band gaps of the quantum dots is applied to the quantum dots, the quantum dots absorb the light undergoing transitions into excited states. While emitting light having a predetermined wavelength, the quantum dots fall to ground states. Here, the wavelength of the emitted light therefrom corresponds to the band gap.

According to an embodiment, the quantum dots may include at least one selected from: compounds of Groups II-VI on the periodic table, compounds of Groups III-V on the periodic table, compounds of Groups IV-VI, elements of Group IV, compounds of GroupIV-IV on the periodic table, and any combination thereof. According to an embodiment, the quantum dots may include an alloy of the foregoing compounds and elements. Here, the alloy may include an alloy of the foregoing compounds and a transition metal.

The quantum dots may have a core-shell structure including a core and a shell covering the core.

For example, the compounds of Groups II-VI may be a Group II-VI semiconductor nanocrystal. The Group II-VI semiconductor nanocrystal may include: a binary compound selected from CdO, CdS, CdSe, CdTe, ZnO, ZnS, ZnSe, ZnTe, HgS, HgSe, HgTe, MgSe, MgS, or any combination thereof; a ternary compound selected from CdSeS, CdSeTe, CdSTe, ZnSeS, ZnSeTe, ZnSTe, HgSeS, HgSeTe, HgSTe, CdZnS, CdZnSe, CdZnTe, CdHgS, CdHgSe, CdHgTe, HgZnS, HgZnSe, HgZnTe, MgZnSe, MgZnS, or any combination thereof; and a quaternary compound selected from HgZnTeS, CdZnSeS, CdZnSeTe, CdZnSTe, CdHgSeS, CdHgSeTe, CdHgSTe, HgZnSeS, HgZnSeTe, HgZnSTe, or any combination thereof. The Group II-VI semiconductor nanocrystal may include an alloy of the foregoing compounds.

For example, the compounds of Groups III-V may be a Group III-V semiconductor nanocrystal. The Group III-V semiconductor nanocrystal may include: a binary compound selected from GaN, GaP, GaAs, AlN, AlP, AlAs, InN, InP, InAs, InSb, and any combination thereof; a ternary compound selected from GaNP, GaNAs, GaNSb, GaPAs, GaPSb, AlNP, AINAs, AINSb, AlPAs, AlPSb, InNP, InNAs, InPAs, InPSb, GaAlNP, or any combination thereof; and a quaternary compound selected from GaAlNAs, GaAlNSb, GaAlPAs, GaAlPSb, GaInNP, GaInNAs, GaInNSb, GaInPAs, GaInPSb, InAlNP, InAlNAs, InAlNSb, InAlPAs, InAlPSb, or any combination thereof. The Group III-V semiconductor nanocrystal may include an alloy of the foregoing compounds.

The Group III-V semiconductor nanocrystals may further include at least one element selected from Group II elements such as Zn, Cd, Hg, and Mg, in addition to Group III and V elements. For example, when the Group III-V semiconductor nanocrystals further include a Group II element, the Group III-V semiconductor nanocrystals may include InZnP.

For example, the compounds of Groups IV-VI may be a Group IV-VI semiconductor nanocrystal. The Group IV-VI semiconductor nanocrystal may include: a binary compound selected from SnS, SnSe, SnTe, PbS, PbSe, PbTe, or any combination thereof; a ternary compound selected from SnSeS, SnSeTe, SnSTe, PbSeS, PbSeTe, PbSTe, SnPbS, SnPbSe, SnPbTe, or any combination thereof; and a quaternary compound selected from SnPbSSe, SnPbSeTe, SnPbSTe, or any combination thereof. The Group IV-VI semiconductor nanocrystal may include an alloy of the foregoing compounds.

For example, the elements of Group IV on the periodic table may be selected from Si, Ge, and any combination thereof.

For example, the compounds of Group IV-IV on the periodic table may be binary compounds selected from SiC, SiGe, and any combination thereof, or alloys of the binary compounds.

Here, the binary compound, the ternary compound, or the quaternary compound may be present in the particles at a uniform concentration, or may be present in the same particle at a concentration divided into partially different states. In addition, the quantum dots may have a core-shell structure so that one quantum dot may be covered by another quantum dot. The interface between the core and the shell may have a concentration gradient in which the concentration of the element existing on the shell becomes lower toward the center.

The core may include at least one compound selected from CdS, CdSe, ZnS, ZnSe, ZnTe, HgS, HgSe, HgTe, CdTe, CdSeS, CdSeTe, CdZnS, CdZnSe, GaN, GaP, GaAs, GaInP, GaInN, InP, InAs, InZnP, and ZnO, or an alloy thereof. For example, the core may include InZnP.

The shell may include at least one compound selected from CdS, CdSe, ZnSe, ZnSeS, ZnS, ZnTe, CdTe, CdO, ZnO, InP, GaN, GaP, GaInP, GaInN, HgS, and HgSe, or an alloy thereof. For example, the shell may include ZnSeS.

The quantum dots having a core-shell structure may have an average core diameter in a range of about 2 nm to about 10 nm and an average shell thickness in a range of about 1 nm to about 10 nm. In addition, the quantum dots may have an average particle diameter in a range of about 3 nm to about 20 nm. The particle diameter can be measured from the TEM photograph.

The quantum dots may have a full width at half maximum (FWHM) of a light-emitting wavelength spectrum which is about 45 nm or less, about 40 nm or less, or about 30 nm or less. In this range, color purity or color reproducibility of the quantum dots may be improved. In addition, light emitted through the quantum dots may be emitted in all directions, and accordingly, a wide viewing angle may be improved.

Although the quantum dots are made of the same materials, the quantum dots may have different emission wavelengths depending on the size of the quantum dots. The smaller the size the quantum dots have, the shorter the wavelength light is emitted. Therefore, by controlling the size of the quantum dots included in the photoresist resin composition, the emission color of the quantum dots may vary in various ways.

In addition, shapes of the quantum dots may be spherical, pyramidal, or multi-arm shapes, nanowires, or cubic nanoparticles, nanotubes, nanofibers, or nano plate-like particles. However, the shapes are not limited thereto, and may include any shape generally utilized in the

### related art.

According to an embodiment, an amount of the quantum dots may be in a range of about 1 part to about 80 parts by weight based on 100 parts by weight of the total amount of the photoresist resin composition. For example, an amount of the quantum dots may be in a range of about 2 parts to about 75 parts by weight, or about 5 parts to about 70 parts by weight based on 100 parts by weight of the total amount of the photoresist resin composition. For example, an amount of the quantum dots may be in a range of about 20 parts to about 60 parts by weight based on 100 parts by weight of the total amount of the photoresist resin composition.

For example, the amount of the quantum dots may be in a range of about 20 parts to about 50 parts by weight based on 100 parts by weight of the total amount of the photoresist resin composition. For example, the amount of the quantum dots may be in a range of about 30 parts to about 50 parts by weight based on 100 parts by weight of the total amount of the photoresist resin composition. For example, the amount of the quantum dots may be in a range of about 30 parts to about 60 parts by weight based on 100 parts by weight of the total amount of the photoresist resin composition. For example, the amount of the quantum dots may be in a range of about 30 parts to about 50 parts by weight based on 100 parts by weight of the total amount of the photoresist resin composition. For example, the amount of the quantum dots may be in a range of about 33 parts to about 47 parts by weight based on 100 parts by weight of the total amount of the photoresist resin composition.

When the amount of the quantum dots is satisfied within the ranges above, the luminance may be improved through sufficient light emission.

The quantum dots and the scatterer are included at a weight ratio in a range of about 2:1 to about 10:1. For example, the quantum dots and the scatterer may be included at a weight ratio in a range of about 2:1 to about 9:1.

Considering the light scattering by the scatterer, the weight ratio at which the quantum dots and the scatterer are included may be appropriately selected within the ranges above.

According to an embodiment, the photoresist resin composition includes a photopolymerizable monomer.

The photopolymerizable monomer may be polymerized when exposed to light to form a pattern during a pattern formation process.

For example, the photopolymerizable monomer may include a monofunctional ester of a (meth)acrylic acid having at least one ethylenically unsaturated double bond, a multifunctional ester of (meth)acrylic acid having at least one ethylenically unsaturated double bond, or any combination thereof. When a photopolymerizable compound has the ethylenically unsaturated double bond, polymerization thereof may be sufficiently performed when exposed to light during the pattern formation process. A pattern having excellent heat resistance, light resistance, and chemical resistance may be formed.

According to an embodiment, the photopolymerizable monomer may include ethylene glycol di(meth)acrylate, diethylene glycol di(meth)acrylate, triethylene glycol di(meth)acrylate, propylene glycol di(meth)acrylate, neopentyl glycol di(meth)acrylate, 1,4-butanediol di(meth)acrylate, 1,6-hexanediol di(meth)acrylate, bisphenol A di(meth)acrylate, pentaerythritol di(meth)acrylate, pentaerythritol tri(meth)acrylate, pentaerythritol tetra(meth)acrylate, pentaerythritol hexa(meth)acrylate, dipentaerythritol di(meth)acrylate, dipentaerythritol tri(meth)acrylate, dipentaerythritol penta(meth)acrylate, dipentaerythritol hexa(meth)acrylate, bisphenol A epoxy(meth)acrylate, ethylene glycol monomethylether (meth)acrylate, trimethylol propane tri(meth)acrylate, tris(meth)acryloyloxyethyl phosphate, novolac epoxy (meth)acrylate, or any combination thereof. For example, the photopolymerizable monomer includes dipentaerythritol hexa(meth)acrylate.

An amount of the photopolymerizable monomer may be from about 0.5 to about 30 parts by weight based on 100 parts by weight of the total amount of the photoresist composition. For example, an amount of the photopolymerizable monomer may be from about 0.5 to about 30 parts by weight based on 100 parts by weight of the total amount of the photoresist composition. For example, an amount of the photopolymerizable monomer may be from about 1 to about 30 parts by weight based on 100 parts by weight of the total amount of the photoresist composition. According to an embodiment, the amount of the photopolymerizable monomer may be from about 5 to about 20 parts by weight based on 100 parts by weight of the total amount of the photoresist composition. When the amount of the photopolymerizable monomer is within this range, a color conversion element prepared by using the photoresist composition may have excellent pattern characteristics and developing properties.

According to an embodiment, the photoresist resin composition includes a photopolymerization initiator.

The photopolymerization initiator may initiate polymerization of the photopolymerizable monomer depending on wavelengths of light such as visible light, ultraviolet light, and far-ultraviolet light.

The photoresist resin composition includes the photopolymerization initiator. Accordingly, high degrees of photocuring thereof may prevent undercut formation in a pattern by formed using the photoresist resin composition. Thus, a color conversion element including a film prepared by using the photoresist resin composition may have excellent pattern characteristics.

The photopolymerization initiator may include an oxime-based compound, an acetophenone-based compound, a thioxanthone-based compound, a benzophenone-based compound, or any combination thereof. For example, the photopolymerization initiator may be an acetophenone-based compound.

The oxime-based compound may include 1-[4-(phenylthio)phenyl]-1,2-octanedione 2-(O-benzoyloxime) , 2-dimethylamino-2-(4-methylbenzyl)-1-(4-morpholine-4-yl-phenyl)-butane-1-one, 1-(4-phenylsulfanylphenyl)-butane-1,2-dione-2-oxime-O-benzoate , 1-(4-phenylsulfanylphenyl)-octane-1,2-dione-2-oxime-O-benzoate, 1-(4-phenylsulfanylphenyl)-octane-1-one oxime-O-acetate, 1-(4-phenylsulfanylphenyl)-butane-1-one-2-oxime-O-acetate, 2-(O-benzoyloxime)-1-[4-(phenylthio)phenyl]-1,2-octanedione, 1-(O-acetyloxime)-1- [9-ethyl-6-(2-methylbenzoyl)-9H-carbazole-3-yl]ethanone, O-ethoxycarbonyl-α-oxyamino-1-phenylpropane-1-one, or any combination thereof.

The acetophenone-based compound may include 4-phenoxy dichloroacetophenone, 4-t-butyl dichloroacetophenone, 4-t-butyl trichloroacetophenone, 2,2-diethoxyacetophenone, 2-hydroxy-2-methyl- 1-phenyl-propane- 1-one, 1-(4-isopropylphenyl)-2-hydroxy-2-methyl-propane-1-one, 1-(4-dodecylphenyl)-2-hydroxy-2-methylpropane-1-one, 4-(2-hydroxyethoxy)-phenyl-(2-hydroxy-2-propyl)ketone, 1-hydroxy cyclohexyl phenyl ketone, 2-methyl-1-[4-(methylthio)phenyl]-2-morpholino-propane-1-one, 2-benzyl-2-dimethylamino-1-(4-morpholinophenyl)-butanone-1, or any combination thereof.

The thioxanthone-based compound may include thioxanthone, 2-chloro thioxanthone, 2-methyl thioxanthone, isopropyl thioxanthone, 2,4-diethyl thioxanthone, 2,4-diisopropyl thioxanthone, or any combination thereof.

The benzophenone-based compound may include benzophenone, benzoyl benzoic acid, benzoyl benzoic acid methyl ester, 4-phenyl benzophenone, hydroxy benzophenone, 4-benzoyl-4'-methyl diphenyl sulfide, 3,3'-dimethyl-4-methoxy benzophenone, or any combination thereof.

According to an embodiment, the photoresist resin composition may include at least one photopolymerization initiator.

For example, the photoresist resin composition may include a first photopolymerization initiator and a second photopolymerization initiator. The first photopolymerization initiator and the second photopolymerization initiator may each independently be selected from the foregoing oxime-based compound, acetophenone-based compound, thioxanthone-based compound, and benzophenone-based compound. Here, the photoresist resin composition may include the first photopolymerization initiator and the second photopolymerization initiator at a weight ratio in a range of about 1:1 to about 50:1. When the weight ratio at which the first photopolymerization initiator and the second photopolymerization initiator are included is within this range, pattern characteristics may be improved due to an increase in photoinitiation efficiency.

According to an embodiment, a total amount of the first photopolymerization initiator and the second photopolymerization initiator in the photoresist resin composition may be in a range of about 0.1 parts to about 15 parts by weight based on 100 parts by weight of the total amount of the photoresist resin composition. When the total amount of the first photopolymerization initiator and the second photopolymerization initiator is within this range, the photopolymerizable monomer may be sufficiently photopolymerized when exposed to light during a pattern forming process, thereby preventing a decrease in transmittance caused by unreacted initiators.

According to an embodiment, the photoresist resin composition includes a binder resin.

The binder resin may increase adhesion between a color conversion element prepared by using the photoresist resin composition and a substrate by adjusting the viscosity of the photoresist resin composition such that a pattern with excellent surface smoothness may be formed during a developing process.

According to an embodiment, the binder resin may be alkali soluble.

According to an embodiment, the binder resin may include an epoxy resin, an acrylic resin, or any combination thereof.

The epoxy resin may improve heat resistance of a pattern formed by using the photoresist resin composition and dispersion stability of the quantum dots such that a pixel having a desired resolution may be formed during the developing process.

According to an embodiment, the epoxy resin may be a phenol novolac epoxy resin, a tetramethyl biphenyl epoxy resin, a bisphenol A epoxy resin, a bisphenol F epoxy resin, an alicyclic epoxy resin, or any combination thereof.

According to another embodiment, an epoxy equivalent weight of the epoxy resin may be from about 150 g/eq to about 200 g/eq. If the epoxy equivalent weight of the epoxy is within this range, hardness of a pattern formed by using the photoresist resin composition may be increased and the quantum dots may efficiently be fixed in a structure in which the pattern is formed.

The acrylic resin may prevent formation of protrusions on a pattern formed by using the photoresist resin composition to improve heat resistance of the pattern, color properties of the pattern, such as brightness and contrast ratio, by increasing transmittance, and chemical resistance of the pattern.

The acrylic resin, which may be a copolymer of a first ethylenically unsaturated monomer and a second ethylenically unsaturated monomer copolymerizable therewith, may be a resin including at least one acrylic repeating unit.

The first ethylenically unsaturated monomer may be an ethylenically unsaturated monomer including at least one carboxyl group. For example, the first ethylenically unsaturated monomer may include acrylic acid, methacrylic acid, maleic acid, itaconic acid, fumaric acid, or any combination thereof.

According to an embodiment, an amount of the first ethylenically unsaturated monomer may be from about 5 to about 50 parts by weight based on 100 parts by weight of a total amount of the acrylic resin. According to another embodiment, the amount of the first ethylenically unsaturated monomer may be from about 10 to about 40 parts by weight based on 100 parts by weight of the total amount of the acrylic resin.

According to an embodiment, the second ethylenically unsaturated monomer may include: an aromatic vinyl compound such as styrene, α-methylstyrene, vinyltoluene, and vinylbenzylmethylether; an unsaturated carboxylic acid ester compound such as methyl(meth)acrylate, ethyl(meth)acrylate, butyl(meth)acrylate, 2-hydroxyethyl(meth)acrylate, 2-hydroxy butyl(meth)acrylate, benzyl(meth)acrylate, cyclohexyl(meth)acrylate, and phenyl(meth)acrylate; an unsaturated carboxylic acid aminoalkyl ester compound such as 2-aminoethyl(meth)acrylate and 2-dimethylaminoethyl(meth)acrylate; a carboxylic acid vinyl ester compound such as vinyl acetate and vinyl benzoate; an unsaturated carboxylic acid glycidyl ester compound such as glycidyl(meth)acrylate; a vinyl cyanide compound such as (meth)acrylonitrile; an unsaturated amide compound such as (meth)acrylamide; or any combination thereof.

According to an embodiment, the acrylic resin may include a (meth)acrylic acid/benzylmethacrylate copolymer, a (meth)acrylic acid/benzylmethacrylate/styrene copolymer, a (meth)acrylic acid/benzylmethacrylate/2-hydroxyethylmethacrylate copolymer, a (meth)acrylic acid/benzylmethacrylate/styrene/2-hydroxyethylmethacrylate copolymer, or any combination thereof.

According to an embodiment, the binder resin may have a weight average molecular weight of about 6,000 g/mol to about 50,000 g/mol. According to another embodiment, the binder resin may have a weight average molecular weight of about 6,000 g/mol to about 16,000 g/mol. When the weight average molecular weight of the binder resin is within these ranges, the photoresist resin composition may have excellent physical and chemical properties and an appropriate viscosity and may provide excellent adhesion between a color conversion element and a substrate.

According to an embodiment, an amount of the binder resin may be from about 1 to about 30 parts by weight based on 100 parts by weight of the total amount of the photoresist resin composition. According to another embodiment, the amount of the binder resin may be from about 5 to about 20 parts by weight based on 100 parts by weight of the total amount of the photoresist resin composition. When the amount of the binder resin is within these ranges, excellent developing properties and high surface smoothness due to increased crosslinking may be obtained while preparing a color conversion element.

According to an embodiment, the photoresist resin composition includes a solvent.

The solvent may be a material having compatibility with the quantum dots, the photopolymerizable monomer, the photopolymerization initiator, and the binder resin but not involved in reactions therewith.

For example, the solvent may include: an alcohol such as methanol and ethanol; an ether such as dichloroethyl ether, n-butyl ether, diisoamyl ether, methylphenyl ether, and tetrahydrofuran; a glycol ether such as ethylene glycol monoethyl ether, ethylene glycol methyl ether, ethylene glycol ethyl ether, and propylene glycol methyl ether; a cellosolve acetate such as methyl cellosolve acetate, ethyl cellosolve acetate, and diethyl cellosolve acetate; a carbitol such as methylethyl carbitol, diethyl carbitol, diethylene glycol monomethyl ether, diethylene glycol monoethyl ether, diethylene glycol dimethylether, diethylene glycol methylethyl ether, and diethylene glycol diethyl ether; a propylene glycol alkyl ether acetate such as propylene glycol monomethyl ether acetate, propylene glycol monoethyl ether acetate, and propylene glycol propyl ether acetate; an aromatic hydrocarbon such as toluene and xylene; a ketone such as methylethylketone, cyclohexanone, 4-hydroxy-4-methyl-2-pentanone, methyl-n-propyl ketone, methyl-n-butyl ketone, methyl-n-amyl ketone, and 2-heptanone; a saturated aliphatic monocarboxylic acid alkyl ester such as ethyl acetate, n-butyl acetate, and isobutyl acetate; a lactic acid alkyl ester such as methyl lactate and ethyl lactate; a hydroxy acetic acid alkyl ester such as methyl hydroxy acetate, ethyl hydroxy acetate, and butyl hydroxy acetate; an acetic acid alkoxy alkyl ester such as methoxymethyl acetate, methoxyethyl acetate, methoxybutyl acetate, ethoxymethyl acetate, and ethoxyethyl acetate; a 3-hydroxypropionic acid alkyl ester such as methyl 3-hydroxypropionate and ethyl 3-hydroxypropionate; a 3-alkoxypropionic acid alkyl ester such as methyl 3-methoxypropionate, ethyl 3-methoxypropionate, ethyl 3-ethoxypropionate, and methyl 3-ethoxypropionate; a 2-hydroxypropionic acid alkyl ester such as methyl 2-hydroxypropionate, ethyl 2-hydroxypropionate, and propyl 2-hydroxypropionate; a 2-alkoxypropionic acid alkyl ester such as methyl 2-methoxypropionate, ethyl 2-methoxypropionate, ethyl 2-ethoxypropionate, and methyl 2-ethoxypropionate; a 2-hydroxy-2-methylpropionic acid alkyl ester such as methyl 2-hydroxy-2-methylpropionate and ethyl 2-hydroxy-2-methylpropionate; a 2-alkoxy-2-methylpropioic acid alkyl ester such as methyl 2-methoxy-2-methylpropionate and ethyl 2-ethoxy-2-methylpropionate; an ester such as 2-hydroxyethyl propionate, 2-hydroxy-2-methylethyl propionate, hydroxyethyl acetate, and methyl 2-hydroxy-3-methylbutanoate; or a ketonic acid ester such as ethyl pyruvate. In addition, the solvent may include N-methylformamide, N,N-dimethylformamide, N-methylformanilide, N-methylacetamide, N,N-dimethylacetamide, N-methylpyrrolidone, dimethylsulfoxide, benzylethylether, dihexylether, acetylacetone, isophorone, caproic acid, caprylic acid, 1-octanol, 1-nonanol, benzyl alcohol, benzyl acetate, ethyl benzoate, diethyl oxalate, diethyl malate, γ-butyrolactone, ethylene carbonate, propylene carbonate, phenyl cellosolve acetate, or any combination thereof.

According to an embodiment, the solvent may include: a glycol ether such as ethylene glycol monoethyl ether; an ethylene glycol alkylether acetate such as ethyl cellosolve acetate; an ester such as 2-hydroxyethyl propionate; a diethylene glycol such as diethylene glycol monomethyl ether; a propylene glycol alkylether acetate such as propylene glycol monomethyl ether acetate, propylene glycol propyl ether acetate; or any combination thereof.

An amount of the solvent may be from about 1 part by weight to 99 parts by weight based on 100 parts by weight of the total amount of the photoresist resin composition. For example, an amount of the solvent may be from about 30 parts by weight to 99 parts by weight, or 70 parts by weight to 98 parts by weight, or 70 parts by weight to 95 parts by weight based on 100 parts by weight of the total amount of the photoresist resin composition. When the amount of the solvent is within this range, the photoresist resin composition may have an appropriate viscosity, such that the efficiency of processing a color conversion element using the photoresist resin composition may be increased.

According to an embodiment, the photoresist resin composition may optionally include an additive.

The photoresist resin composition may further include an additive. The additive may include a thermal curing agent, a dispersant, an antioxidant, an UV absorbent, or any combination thereof.

The photoresist resin composition may further include a thermal curing agent to increase curing efficiency and curing rate of the composition.

For example, the thermal curing agent may include 2-mercaptobenzoimidazole, 2-mercaptobenzothiazole, 2-mercaptobenzoxazole, 2,5-dimercapto-1,3,4-thiadiazole, 2-mercapto-4,6-dimethylaminopyridine, pentaerythritol tetrakis(3-mercaptopropionate), pentaerythritol tris(3-mercaptopropionate), pentaerythritol tetrakis(2-mercaptoacetate), pentaerythritol tris(2-mercaptoacetate), trimethylolpropane tris(2-mercaptoacetate), trimethylolpropane tris(3-mercaptopropionate), trimethylolethane tris(2-mercaptoacetate), and trimethylolethane tris(3-mercaptopropionate), or any combination thereof.

The photoresist resin composition may further include a dispersant to increase dispersibility of the quantum dots.

For example, the dispersant may include a commercially available surfactant. The dispersant may include a silicon-based surfactant, a fluorine-based surfactant, an ester surfactant, a cationic surfactant, an anionic surfactant, a nonionic surfactant, an amphoteric surfactant, or any combination thereof. According to an embodiment, the dispersant may include a polyoxyethylenealkylether, a polyoxyethylenealkylphenylether, a polyethyleneglycoldiester, a sorbitan fatty acid ester, a fatty acid-modified polyester, a tertiary amine-modified polyurethane, a polyethylene imine, or any combination thereof. According to another embodiment, the dispersant may include a commercially available product such as KP (manufactured by Shin-Etsu Chemical Co., Ltd.), POLYFLOW (manufactured by Kyoeisha Chemical Co., Ltd.), EFTOP (manufactured by Tohkem Products Corporation), MEGAFACE (manufactured by Dainippon Ink and Chemicals, Inc.), Fluorad (manufactured by Sumitomo 3M, Ltd.), Asahi Guard and Surflon (manufactured by Asahi Glass Co., Ltd.), SORSPERSE (manufactured by Zeneka Co.), EFKA (manufactured by EFKA Chemicals), PB 821 (manufactured by Ajinomoto Fine-Techno Co., Ltd.), or any combination thereof.

Examples of the antioxidant may include 2,2'-thiobis(4-methyl-6-t-butylphenol), 2,6-di-t-butyl-4-methylphenol, or any combination thereof, and examples of the UV absorbent may include 2-(3-tert-butyl-2-hydroxy-5-methylphenyl)-5-chlorobenzotriazole, alkoxybenzophenone, or any combination thereof.

According to an embodiment, an amount of the additive may be from about 0.01 parts by weight to about 10 parts by weight based on 100 parts by weight of the total amount of the photoresist resin composition.

According to another aspect of the present disclosure, there is provided the photoresist resin composition prepared by adding the plurality of quantum dots, the photopolymerizable monomer, the photopolymerization initiator, the binder resin, and the solvent to an agitator and stirring the mixture at room temperature for 30 minutes to 1 hour. Here, an additive may be further included to obtain desired properties of the photoresist resin composition.

The quantum dots, the photopolymerizable monomer, the photopolymerization initiator, the binder resin, the solvent, and the additive may be as described above.

According to another aspect of the present disclosure, there is provided a film prepared by performing heat treatment on the photoresist resin composition. For example, the film may not include the solvent.

According to an embodiment, the film may be prepared on a substrate by using the photoresist resin composition according to methods well known in the art. For example, the film may be prepared by (i) a coating process of coating a substrate with the photoresist resin composition; (ii) a solvent-removing process of removing a solvent from the coated photoresist resin composition; (iii) a light-exposing process of exposing the photoresist resin composition from which the solvent is removed to a pattern shape by actinic light; (iv) a developing process of developing the exposed photoresist resin composition with an aqueous developing solution; and (v) a heat-treating process preformed on the developed photoresist resin composition.

According to another aspect of the present disclosure, there is provided a color conversion element including the film.

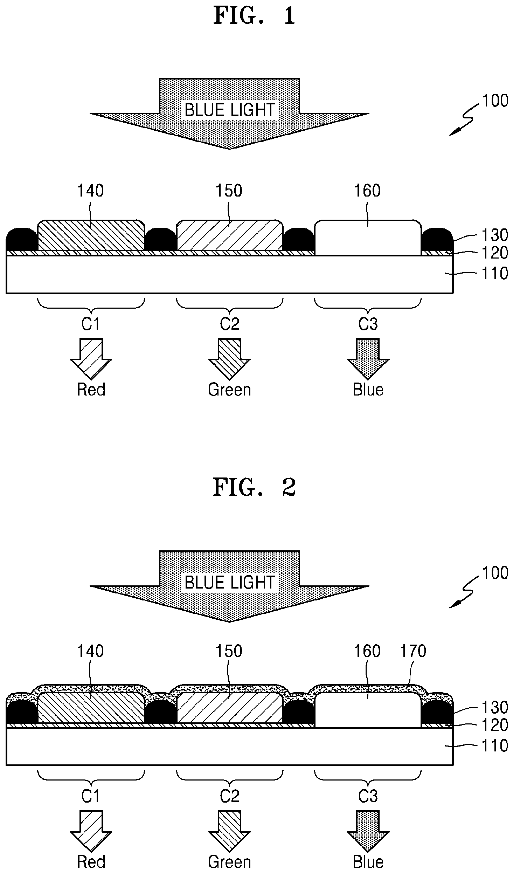

FIG. 1 is a schematic diagram of a structure of a color conversion element 100 according to an embodiment.

Referring to FIG. 1, the color conversion element 100 includes a first region C1, a second region C2, and a third region C3 to realize different colors. For example, when external light (e.g., blue light) is incident on the color conversion element 100, the first region C1, the second region C2, and the third region C3 may emit red light, green light, and blue light, respectively.

The first region C1 may convert incident light into light having a longer wavelength than the incident light and emit the converted light.

According to an embodiment, the first region C1 may include a first film 140 prepared by using the photoresist resin composition including the plurality of the quantum dots. Here, the quantum dots may be the same as those described above. As described above, the quantum dots may emit light having a wavelength of about 620 nm to about 670 nm (i.e., red light) when external light (e.g., blue light) is applied thereto. Thus, when blue light is incident on the first region C1, the blue light may be converted into red light by the quantum dots included in the first film 140.

The first film 140 may further include a scatterer. Here, the scatterer may be as described above. The scatterer may scatter the light incident on the first film 140 so that the front luminance and the side luminance of light emitted from the first film 140 may become uniform, thereby increasing the color reproducibility. In addition, the scatterer may scatter the incident light so that a contact efficiency between the incident light and the quantum dots may be increased, thereby improving the light conversion efficiency.

According to an embodiment, the first region C1 may further include a first band-cut filter 120 to prevent emission of blue light that is not converted by the first film 140 from the first region C1.

The first band-cut filter 120 may refer to a filter that selectively transmits light having a specific band. For example, the first band-cut filter 120 may transmit light having a specific band, and include a single layer or multiple layers for absorbing or reflecting light outside the specific band. Here, when the first band-cut filter 120 includes multiple layers, each of the multiple layers includes different materials and have different refractive indexes. For example, the first band-cut filter 120 may be a yellow-color filter that absorbs blue light and transmits light other than the blue light.

The second region C2 may convert incident light into a second color light having a longer wavelength than the incident light and emit the converted light.

According to an embodiment, the second region C2 may include a second film 150 prepared by using the photoresist resin composition including the plurality of the quantum dots. Here, the quantum dots may be the same as those described above. As described above, the quantum dots may emit light having a wavelength of about 520 nm to about 570 nm (i.e., green light) when external light (e.g., blue light) is applied thereto. Thus, when blue light is incident on the second region C2, the blue light may be converted into green light by the quantum dots included in the second film 150.

The second film 150 may further include a scatterer. Here, the scatterer may be as described above. The scatterer may scatter the light incident on the second film 150 so that the front luminance and the side luminance of light emitted from the second film 150 may become uniform. In addition, the scatterer may scatter the incident light so that a contact efficiency between the incident light and the quantum dots may be increased, thereby improving the light conversion efficiency.

According to another embodiment, the second region C2 may further include the first band-cut filter 120 to prevent emission of blue light that is not converted by the second film 150 from the second region C2.

Third region C3 may include a third film 160 including the scatterer that scatters incident light. Since the third film 160 passes the incident blue light as it is, the third region C3 emits the blue light.

The scatterer may scatter the light incident on the third film 160 so that the front luminance and the side luminance of light emitted from the third film 160 may become uniform.

FIG. 2 is a schematic diagram of a structure of a color conversion element according to another embodiment.

Referring to FIG. 2, in order to transmit incident light, but prevent emission of color-converted light toward the incident light, a second band-cut filter 170 may be further disposed on a surface of the first film 140, the second film 150, and the third film 160 on which light is incident.

According to an embodiment, the second band-cut filter 170 may refer to a filter that emits light having a specific band and reflects light other than the light having the specific band. For example, the second band-cut filter 170 may be a filter that transmits blue light, but reflects green light and red light. The second band-cut filter 170 may be arranged on a surface of the first film 140, the second film 150, and the third film 160 on which light is incident, so that color-converted light emitted from the quantum dots toward the incident light may be reflected and emitted to the outside. Therefore, the light conversion efficiency may be increased through the second band-cut filter 170.

According to an embodiment, the second band-cut filter 170 may include a single layer or multiple layers.

For example, the second band-cut filter 170 may include multiple layers, wherein each of the multiple layers includes different materials and have different refractive indexes. For example, the second band-cut filter 170 may include multiple layers in which a first layer and a second layer are alternatively stacked. For example, the first layer may have a low refractive index, whereas the second layer may have a high refractive index.

According to an embodiment, the second band-cut filter 170 may include Si oxide, Si carbide, Si nitride, or metal oxide. For example, the first layer may include Si oxide, Si carbide, or Si nitride, and the second layer may include an oxide of Ti, Ta, Hf, and Zr. Alternatively, the first layer may include an oxide of Ti, Ta, Hf, and Zr, and the second layer may include Si oxide, Si carbide, or Si nitride.

According to an embodiment, the second band-cut filter 170 may include a Si nitride layer and a Si oxide layer. For example, the second band-cut filter 170 may include multiple layers in which a Si nitride layer and a Si oxide layer are alternatively stacked.

According to an embodiment, the first region C1, the second region C2, and the third region C3 may be disposed on a transparent substrate 110. Barrier walls 130 may be formed on the transparent substrate 110 to partition each of the regions C1 to C3.

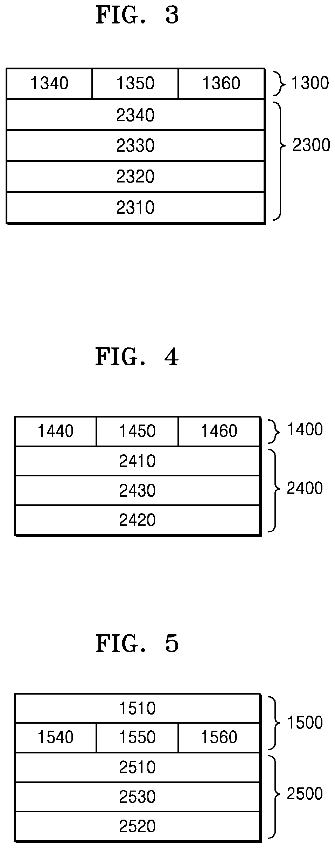

Referring FIGS. 3 to 5, there is provided an electronic apparatus including color conversion elements 1300, 1400, and 1500 and display apparatuses 2300, 2400, and 2500.

According to an embodiment, the color conversion elements 1300, 1400, and 1500 may be as described in FIGS. 1 and 2. The electronic apparatus may include a first film 1340 configured to convert incident light emitted from the display apparatus into a first color light and emitting the first color light; a second film 1350 configured to convert incident light emitted from the display apparatus into a second color light and emitting the second color light; and a third film 1360 configured to transmit incident light emitted from the display apparatus.

According to an embodiment, the electronic apparatus may further include, although not specifically illustrated, a first band-cut filter disposed on the color conversion element and configured to prevent emission of light having the same wavelength range as the incident light. The first band-cut filter may be as described above.

According to an embodiment, the first color light may be red light, and the second color light may be green light.

According to an embodiment the electronic apparatus may further include, although not specifically illustrated, the second band-cut filter disposed between the display apparatus and the color conversion element and configured to prevent emission of light emitted from the conversion element toward the display apparatus. The second band-cut filter may be as described above.

According to an embodiment, the display apparatus may include a liquid crystal display apparatus, an organic light-emitting display apparatus, or an inorganic light-emitting display apparatus.

According to an embodiment, the display apparatus may include a liquid crystal display apparatus, and the liquid crystal display apparatus may include a light source for emitting blue light.

Referring to FIG. 3, a liquid crystal display apparatus 2300 may include a liquid crystal layer 2340, a thin film transistor (TFT) array layer 2330, and a substrate 2320, and may further include a light source 2310 for emitting blue light.

Although not illustrated, the liquid crystal display apparatus 2300 may include a common electrode between the liquid crystal layer 2340 and the color conversion element 1300 and a pixel electrode between the liquid crystal layer 2340 and the TFT array layer 2330. Due to the liquid crystal layer 2340 between the pixel electrode and the common electrode, liquid crystal molecules may be aligned in a predetermined direction by the electric field produced by the pixel electrode and the common electrode, thereby controlling light amount by preventing or passing light.

In addition, although not illustrated, the liquid crystal display apparatus 2300 may include a first alignment layer between the liquid crystal layer 2340 and the common electrode and a second alignment layer between the liquid crystal layer 2340 and the pixel electrode.

The first and second alignment layers may be responsible for uniformly aligning liquid crystal molecules, and may be formed by method well known in the art. For example, the first and second alignment layers may each include polyimide.

In addition, the TFT array layer 2330 may include a plurality of transistors (not shown) and gate lines and data lines respectively applying gate signals and data signals to the plurality of transistors. The pixel electrode may be connected to a drain electrode of a transistor included in the TFT array layer, and receive a data voltage.

In addition, although not illustrated, the liquid crystal display apparatus 2300 may include a first polarizer between the common electrode and the color conversion element 1300.

The first polarizer may be a wire-grid polarizer (WGP). The WGP may include a regular array of micro metallic wires that are arranged in parallel. The WGP reflects polarizing components parallel to the metal grids, and transmits polarizing components perpendicular to the metal grids, thereby providing high efficiency and high luminance. In addition, the first polarizer may be a thin film formed of a polymer material.

In addition, although not illustrated, the liquid crystal display apparatus 2300 may include a second polarizer between the light source 2310 and the substrate 2320.

The substrate 2320 may be formed of various materials, such as glass or transparent plastic. According to an embodiment, the substrate 2320 may include a flexible substrate.

The light source 2310 may be a backlight unit emitting blue light.

Referring to FIG. 4, the display apparatus may be an organic light-emitting display apparatus 2400 emitting blue light.

According to an embodiment, the display apparatus may include an organic light-emitting display apparatus, which includes an organic light-emitting device, wherein the organic light-emitting device includes an organic light-emitting layer including an organic compound and emitting blue light.

The organic light-emitting display apparatus 2400 may include a light-emitting layer 2410 that emits blue light, a TFT array layer 2430, and a substrate 2420.

The TFT array layer 2430 and the substrate 2420 may be as described above.

The organic light-emitting display apparatus 2400 may include an organic light-emitting device disposed between the TFT array layer 2430 and the color conversion element 1400 and configured to emit blue light. Such an organic light-emitting device may be, although not specifically illustrated, include: a first electrode; a second electrode facing the first electrode; and an organic layer disposed between the first electrode and the second electrode and including an emission layer 2410, wherein the organic layer may include i) a hole transport region disposed between the first electrode and the emission layer 2410 and including a hole injection layer, a hole transport layer, a buffer layer, an electron blocking layer, or any combination thereof, and ii) an electron transport layer disposed between the emission layer 2410 and the second electrode and including a hole blocking layer, a buffer layer, an electron transport layer, an electron injection layer, or any combination thereof.

According to an embodiment, the organic light-emitting device may include an organic layer including at least two emission layers. For example, the organic light-emitting device may include, between the first electrode and the second electrode, an organic layer including at least two light-emitting units that each include a hole transport layer, an emission layer, and an electron transport layer. In addition, between the at least two light-emitting units, a charge generation layer (CGL) may be further included.

The electronic apparatus of FIG. 4 may be fabricated according to a sequential stacking process from the substrate to the color conversion element. In this regard, a process of fabricating the color conversion element on the substrate may be omitted, resulting in advantages of simplifying the process.

According to another embodiment, referring to FIG. 5, the color conversion element may be separately fabricated on the substrate 1510, and then, subjected to the process of disposing the color conversion element on the organic light-emitting display apparatus, thereby fabricating the electronic apparatus. Except for substrate 1510, the color conversion element of FIG. 5 and the display apparatus of FIG. 5 may be as the same as those described with reference to FIG. 4 (e.g. first film 1540, second film 1550, third film 1560, light-emitting layer 2510, TFT array layer 2530, substrate 2520).

According to another embodiment, the display apparatus may include an inorganic light-emitting display apparatus, which includes an inorganic light-emitting device, wherein the inorganic light-emitting device includes an inorganic light-emitting layer including an inorganic compound and emitting blue light.

In FIGS. 4 and 5, the organic light-emitting display apparatus is described as an example of the display apparatuses. However, the organic light-emitting display apparatus may be replaced by an inorganic light-emitting device including inorganic light-emitting layers 2410 and 2510 including an inorganic compound, e.g., an inorganic fluorescent substance or a quantum dot. Here, the descriptions of FIGS. 4 and 5 may be applied the same in FIG. 5, except that the inorganic light-emitting device is used instead of the organic light-emitting device.

Hereinafter, the photoresist resin composition and the color conversion element according to one or more embodiments will be described in more detail, according to the following synthesis examples, examples, and comparative examples.

### Examples

### Preparation of photoresist resin composition

Preparation Example 1 (quantum dot (QD) 33 parts by weight, TiO₂ 11.5 parts by weight, based on the solid content of the photoresist resin composition)

Quantum dot inorganic particles InZnP/ZnSeS (12 wt%, 33 parts by weight the solid content), a photopolymerizable monomer (Kayarad DPHA which is dipenthaerythiritol hexa acrylate)( 7 wt%), a photopolymerization initiator (Irgacure^{®} 369 which is 2-Benzyl-2-dimethylamino-1-(4-morpholinophenyl)-butanone-1) (1 wt%), a scatterer (TiO₂)(3.5 wt%, 11.5 parts by weight based on the solid content), a binder resin (alkali soluble resin)(6.5 wt%), and a solvent (propylene glycol methyl ether also known as PGME)(70 wt%) were added to a reactor, and the mixture was stirred to thereby prepare a photoresist resin composition.

### Preparation Example 2

A photoresist resin composition was prepared in the same manner as in Preparation Example 1, except that 35 parts by weight of QD and 8 parts by weight of TiO₂, based on the solid content, were used in preparing the photoresist resin composition.

### Preparation Example 3

A photoresist resin composition was prepared in the same manner as in Preparation Example 1, except that 35 parts by weight of QD and 15 parts by weight of TiO₂, based on the solid content, were used in preparing the photoresist resin composition.

### Preparation Example 4

A photoresist resin composition was prepared in the same manner as in Preparation Example 1, except that 40 parts by weight of QD and 6.5 parts by weight of TiO₂, based on the solid content, were used in preparing the photoresist resin composition.

### Preparation Example 5

A photoresist resin composition was prepared in the same manner as in Preparation Example 1, except that 40 parts by weight of QD and 11.5 parts by weight of TiO₂, based on the solid content, were used in preparing the photoresist resin composition.

### Preparation Example 6

A photoresist resin composition was prepared in the same manner as in Preparation Example 1, except that 40 parts by weight of QD and 16.5 parts by weight of TiO₂, based on the solid content, were used in preparing the photoresist resin composition.

### Preparation Example 7

A photoresist resin composition was prepared in the same manner as in Preparation Example 1, except that 45 parts by weight of QD and 8 parts by weight of TiO₂, based on the solid content, were used in preparing the photoresist resin composition.

### Preparation Example 8

A photoresist resin composition was prepared in the same manner as in Preparation Example 1, except that 45 parts by weight of QD and 15 parts by weight of TiO₂, based on the solid content, were used in preparing the photoresist resin composition.

### Preparation Example 9

A photoresist resin composition was prepared in the same manner as in Preparation Example 1, except that 47 parts by weight of QD and 11.5 parts by weight of TiO₂, based on the solid content, were used in preparing the photoresist resin composition.

### Preparation Example 10

A photoresist resin composition was prepared in the same manner as in Preparation Example 1, except that 40 parts by weight of QD and 25 parts by weight of TiO₂, based on the solid content, were used in preparing the photoresist resin composition.

### Preparation Example 11

A photoresist resin composition was prepared in the same manner as in Preparation Example 1, except that 40 parts by weight of QD and 1 part by weight of TiO₂, based on the solid content, were used in preparing the photoresist resin composition.

### Evaluation Example 1: Evaluation of light absorption rate of QDs

### Manufacture of reference light spectrum

Prior to the evaluation of light absorption rate of the QDs, to obtain reference data, a photoresist resin composition prepared in the same manner as in Preparation Example 1, except that the QD inorganic particles were not included, was applied onto a glass substrate according to a spin coating method. Then, the glass substrate was dried at a temperature of 100°C for 3 minutes so that a thin film was formed thereon.

The thin film was placed on a QE-2100 (manufactured by Otsuka Electronics Co., Ltd), and then, a light source was irradiated thereto, thereby obtaining a reference excitation light spectrum.

### Example 1

The photoresist resin composition of Preparation Example 1 was applied to a glass substrate according to a spin coating method, and then, the glass substrate was dried at a temperature of 100°C for 3 minutes, thereby forming a thin film thereon.

The thin film was placed on a QE-2100 (manufactured by Otsuka Electronics Co., Ltd), and then, a light source was irradiated thereto, thereby obtaining a reference excitation light spectrum.

### Examples 2 to 9

Reference excitation light spectra were obtained in the same manner as in Example 1, except that the photoresist resin compositions of Preparation Examples 2 to 9 were each used instead of the photoresist resin composition of Preparation Example 1.

### Comparative Examples 1 and 2

Reference excitation light spectra were obtained in the same manner as in Example 1, except that the photoresist resin compositions of Preparation Examples 10 and 11 were each used instead of the photoresist resin composition of Preparation Example 1.

### Evaluation of light absorption rate

According to the light spectra obtained in Examples 1 to 9 and Comparative Examples 1 and 2, peaks in the same wavelength band as the reference excitation light spectrum were resulted by absorbed photons, whereas peaks that were not shown in the reference excitation light spectrum were resulted by light-converted photons. Therefore, in the reference excitation light spectrum and the light spectra obtained in Examples 1 to 9, the light absorption rate may be calculated by comparing the area of the peaks resulted by the absorbed photons, and the calculation results are shown in Table 1.

**(Table 1)**

| No. | Materials (A+B) | A (wt%) | B (wt%) | Absorption rate |
|---|---|---|---|---|
| Example 1 | QD + TiO2 | 33 | 11.5 | 83.1 |
| Example 2 | QD + TiO2 | 35 | 8 | 79 |
| Example 3 | QD + TiO2 | 35 | 15 | 86.9 |
| Example 4 | QD + TiO2 | 40 | 6.5 | 82.3 |
| Example 5 | QD + TiO2 | 40 | 11.5 | 87.1 |
| Example 6 | QD + TiO2 | 40 | 16.5 | 92.0 |
| Example 7 | QD + TiO2 | 45 | 8 | 86.0 |
| Example 8 | QD + TiO2 | 45 | 15 | 91.3 |
| Example 9 | QD + TiO2 | 47 | 11.5 | 89.9 |
| Comparative Example 1 | QD + TiO2 | 40 | 25 | 63.5 |
| Comparative Example 2 | QD + TiO2 | 40 | 1 | 15 |

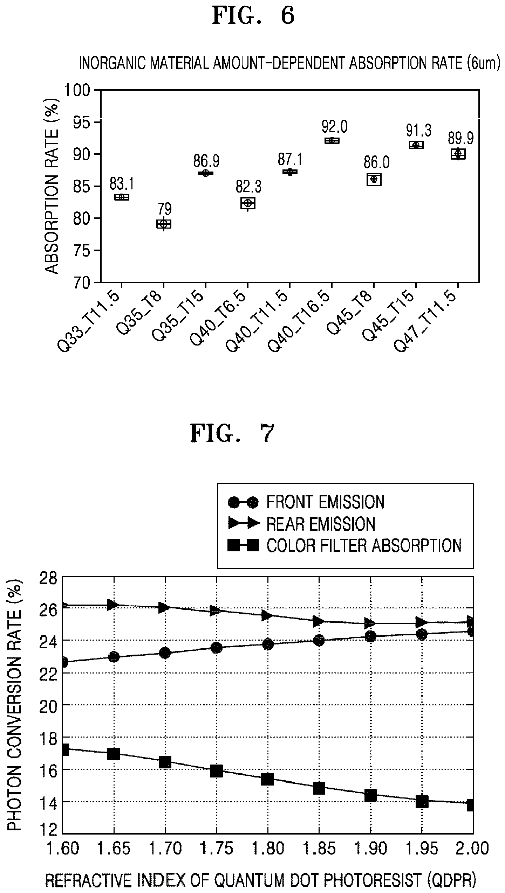

As shown in Table 1 and FIG. 6, it was confirmed that, as the amounts of the QDs and the scatter in the photoresist resin composition were controlled, the light absorption rates by the QDs were also changed, resulting in the overall increase in the absorption rates with the increase of the amount of the scatterer.

Evaluation Example 2: Evaluation of simulation on color conversion element regarding emission conversion rate

### Example 10

TiO₂ Mie scattering material with low refractive materials (thin film transmittance) was combined with Monte Carlo method based on Ray tracing, Custom code with Python 2.7. Then, a backlight unit was defined with a random distribution after being approximated to the actual spectrum, and a photo scattering angle was defined with a random distribution after the scattering of TiO₂ based on the Mie scattering process.

Here, QDs, quantum yield and absorption spectrum, concentrations of QDs and TiO₂, thickness of the thin film including the QD photoresist resin composition, transmission spectrum of the band-cut filters, and refractive index of each layer were set as parameters.

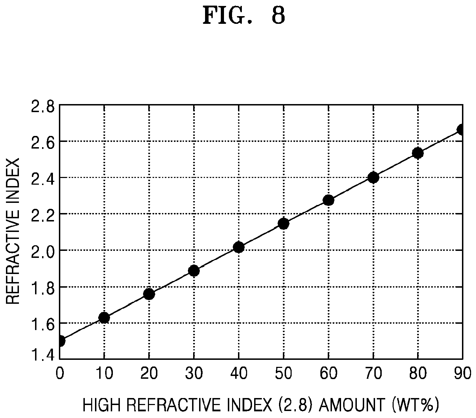

The results of simulation of the emission conversion rate of the color conversion element represent the light conversion rate versus the refractive index of the color filter including the thin film including the photoresist resin composition, and are shown in FIG. 7. As shown in FIG. 8, the refractive index was calculated from the graphs showing the changes in the refractive indexes with the addition of the scatters with a refractive index of 2.8, according to the Vegard principle.

As shown in FIG. 7, as the refractive index of the thin film including the photoresist resin composition increased, the frontal photon conversion rate also increased while the rear photon conversion rate tended to decrease. That is, based on the increase of the refractive index of the photoresist resin composition, the increase in the frontal emission efficiency and the improvement in the front emission luminance may be expected.

According to the one or more embodiments, a color conversion element including a film that is prepared by using a photoresist resin composition may have excellent luminescent efficiency and color reproducibility.

It should be understood that embodiments described herein should be considered in a descriptive sense only and not for purposes of limitation. Descriptions of features or aspects within each embodiment should typically be considered as available for other similar features or aspects in other embodiments.

While one or more embodiments have been described with reference to the figures, it will be understood by those of ordinary skill in the art that various changes in form and details may be made therein without departing from the scope as defined by the following claims.

## Claims

1. A photoresist resin composition, comprising:
a plurality of quantum dots;
a photopolymerizable monomer;
a photopolymerization initiator;
a scatterer;
a binder resin; and
a solvent,
wherein an amount of the scatterer is in a range of about 2 parts to about 20 parts by weight based on 100 parts by weight of a total amount of the photoresist resin composition; and
**characterized in that** the photoresist resin composition comprises the quantum dots and the scatterer at a weight ratio in a range of 2:1 to 10:1.

2. A photoresist resin composition according to claim 1, wherein the scatterer comprises a plurality of inorganic particles having different particle diameters from each other;
wherein the plurality of the inorganic particles each have a particle diameter of greater than 20 nm and less than 2 µm; and/or
wherein the plurality of the inorganic particles each have a refractive index of greater than 1.5.

3. A photoresist resin composition according to claim 1 or claim 2, wherein the scatterer comprises at least one compound selected from the group consisting of BiFeO₃, Fe₂O₃, WO₃, TiO₂, SiC, BaTiO₃, ZnO, ZrO₂, ZrO, Ta₂O₅, MoO₃, TeO₂, Nb₂O₅, Fe₃O₄, V₂O₅, Cu₂O, BP, Al₂O₃, In₂O₃, SnO₂, Sb₂O₃, and ITO.

4. A photoresist resin composition according to any one of claims 1 to 3, wherein the quantum dots comprise at least one selected from the group consisting of a compound of Groups II-VI, a compound of Groups III-V, a compound of Groups IV-VI, a compound of Group IV-IV, and an element of Group IV, or an alloy thereof, and
have a core-shell structure including a core and a shell covering the core; optionally wherein the core comprises at least one compound selected from the group consisting of CdS, CdSe, ZnS, ZnSe, ZnTe, HgS, HgSe, HgTe, CdTe, CdSeS, CdSeTe, CdZnS, CdZnSe, GaN, GaP, GaAs, GaInP, GaInN, InP, InAs, InZnP, ZnO, and an alloy thereof, and
the shell comprises at least one compound selected from the group consisting of CdS, CdSe, ZnSe, ZnS, ZnSeS, ZnTe, CdTe, CdO, ZnO, InP, GaN, GaP, GaInP, GaInN, HgS, HgSe, and an alloy thereof.

5. A photoresist resin composition according to any one of claims 1 to 4, wherein:
the quantum dots have an average particle diameter in a range of 3 nm to 20 nm; and/or
an amount of the quantum dots is in a range of 20 parts to 60 parts by weight based on 100 parts by weight of the total amount of the photoresist resin composition.

6. A photoresist resin composition according to any one of claims 1 to 5, wherein the photopolymerizable monomer comprises at least one compound selected from the group consisting of ethylene glycol di(meth)acrylate, diethylene glycol di(meth)acrylate, triethylene glycol di(meth)acrylate, propylene glycol di(meth)acrylate, neopentyl glycol di(meth)acrylate, 1,4-butanediol di(meth)acrylate, 1,6-hexanediol di(meth)acrylate, bisphenol A di(meth)acrylate, pentaerythritol di(meth)acrylate, pentaerythritol tri(meth)acrylate, pentaerythritol tetra(meth)acrylate, pentaerythritol hexa(meth)acrylate, dipentaerythritol di(meth)acrylate, dipentaerythritol tri(meth)acrylate, dipentaerythritol penta(meth)acrylate, dipentaerythritol hexa(meth)acrylate, bisphenol A epoxy(meth)acrylate, ethylene glycol monomethylether (meth)acrylate, trimethylol propane tri(meth)acrylate, tris(meth)acryloyloxyethyl phosphate, and novolac epoxy (meth)acrylate.

7. A photoresist resin composition according to any one of claims 1 to 6, wherein the photopolymerization initiator comprises at least one compound selected from the group consisting of an oxime-based compound, an acetophenone-based compound, a thioxanthone-based compound, and a benzophenone-based compound.

8. A photoresist resin composition according to any one of claims 1 to 7, wherein the binder resin comprises at least one resin selected from the group consisting of an epoxy resin and an acrylic resin.

9. A photoresist resin composition according to any one of claims 1 to 8, wherein the solvent comprises at least one compound selected from the group consisting of ethylene glycol monoethyl ether, ethyl cellosolve acetate, 2-hydroxyethyl propionate, diethylene glycol monomethyl ether, propylene glycol monomethyl ether acetate, and propylene glycol propyl ether acetate.

10. A film prepared by performing heat treatment on the photoresist resin composition according to any one of claims 1 to 9.

11. A color conversion element comprising the film according to claim 10.

12. An electronic apparatus comprising the color conversion element according to claim 11 and a display apparatus.

13. An electronic apparatus according to claim 12, wherein the display apparatus comprises a liquid crystal display apparatus, an organic light-emitting apparatus, or an inorganic light-emitting apparatus.

14. An electronic apparatus according to claim 13, wherein:
the display apparatus comprises the liquid crystal display apparatus, and the liquid crystal display apparatus comprises a light source configured to emit blue light; or
the display apparatus comprises the organic light-emitting apparatus, which comprises an organic light-emitting device, and
wherein the organic light-emitting device comprises an organic light-emitting layer comprising an organic compound configured to emit blue light; or
the display apparatus comprises the inorganic light-emitting apparatus, which comprises an inorganic light-emitting device, and wherein the inorganic light-emitting device comprises an inorganic light-emitting layer comprising an inorganic compound configured to emit blue light.

## Patentansprüche

1. Fotoresistharzzusammensetzung, Folgendes umfassend:
eine Vielzahl von Quantenpunkten,
ein fotopolymerisierbares Monomer,
einen Initiator der Fotopolymerisation,
einen Streuer,
ein Bindeharz und
ein Lösemittel,
wobei eine Menge des Streuers, bezogen auf 100 Gewichtsteile einer Gesamtmenge der Fotoresistharzzusammensetzung, im Bereich von etwa 2 Gewichtsteilen bis etwa 20 Gewichtsteile liegt; und
**dadurch gekennzeichnet, dass** die Fotoresistharzzusammensetzung die Quantenpunkte und den Streuer in einem Gewichtsverhältnis im Bereich von 2:1 bis 10:1 umfasst.

2. Fotoresistharzzusammensetzung nach Anspruch 1, wobei der Streuer eine Vielzahl von anorganischen Partikeln mit voneinander verschiedenen Partikeldurchmessern umfasst;
wobei die Vielzahl von anorganischen Partikeln jeweils einen Partikeldurchmesser von mehr als 20 nm und weniger als 2 µm aufweisen; und/oder
wobei die Vielzahl von anorganischen Partikeln jeweils einen Brechungsindex von mehr als 1,5 aufweisen.

3. Fotoresistharzzusammensetzung nach Anspruch 1 oder Anspruch 2, wobei der Streuer mindestens eine Verbindung umfasst, die aus der Gruppe ausgewählt ist, die aus BiFeO₃, Fe₂O₃, WO₃, TiO₂, SiC, BaTiO₃, ZnO, ZrO₂, ZrO, Ta₂O₅, MoO₃, TeO₂, Nb₂O₅, Fe₃O₄, V₂O₅, Cu₂O, BP, Al₂O₃, In₂O₃, SnO₂, Sb₂O₃ und ITO besteht.

4. Fotoresistharzzusammensetzung nach einem der Ansprüche 1 bis 3, wobei die Quantenpunkte mindestens eines umfassen, das ausgewählt ist aus der Gruppe bestehend aus einer Verbindung der Gruppen II-VI, einer Verbindung der Gruppen III-V, einer Verbindung der Gruppen IV-VI, einer Verbindung der Gruppe IV-IV und einem Element der Gruppe IV oder einer Legierung daraus, und
eine Kern-Mantel-Struktur aufweisen, die einen Kern und einen den Kern bedeckenden Mantel einschließt, wobei der Kern optional mindestens eine Verbindung umfasst, die ausgewählt ist aus der Gruppe bestehend aus CdS, CdSe, ZnS, ZnSe, ZnTe, HgS, HgSe, HgTe, CdTe, CdSeS, CdSeTe, CdZnS, CdZnSe, GaN, GaP, GaAs, GaInP, GaInN, InP, InAs, InZnP, ZnO und einer Legierung daraus, und
der Mantel mindestens eine Verbindung umfasst, die ausgewählt ist aus der Gruppe bestehend aus CdS, CdSe, ZnSe, ZnS, ZnSeS, ZnTe, CdTe, CdO, ZnO, InP, GaN, GaP, GaInP, GaInN, HgS, HgSe und einer Legierung daraus.

5. Fotoresistharzzusammensetzung nach einem der Ansprüche 1 bis 4, wobei:
die Quantenpunkte einen durchschnittlichen Partikeldurchmesser im Bereich von 3 nm bis 20 nm aufweisen und/oder
eine Menge der Quantenpunkte, bezogen auf 100 Gewichtsteile der Gesamtmenge der Fotoresistharzzusammensetzung, im Bereich von etwa 20 Gewichtsteilen bis etwa 60 Gewichtsteile liegt.

6. Fotoresistharzzusammensetzung nach einem der Ansprüche 1 bis 5, wobei das fotopolymerisierbare Monomer mindestens eine Verbindung umfasst, die aus der Gruppe bestehend aus Ethylenglycoldi(meth)acrylat, Diethylenglycoldi(meth)acrylat, Triethylenglycoldi(meth)acrylat, Propylenglycoldi(meth)acrylat, Neopentylglycoldi(meth)acrylat, 1,4-Butandioldi(meth)acrylat, 1,6-Hcxandioldi(meth)acrylat, Bisphenol-A-di(meth)acrylat, Pentaerythritoldi(meth)acrylat, Pentaerythritoltri(meth)acrylat, Pentaerythritoltetra(meth)acrylat, Pentaerythritolhexa(meth)acrylat, Dipentaerythritoldi(meth)acrylat, Dipentaerythritoltri(meth)acrylat, Dipentaerythritolpenta(meth)acrylat, Dipentaerythritolhexa(meth)acrylat, Bisphenol-A-epoxy(meth)acrylat, Ethylenglycolmonomethylether(meth)acrylat, Trimethylolpropantri(meth)acrylat, Tris(meth)acryloyloxyethylphosphat und Novolacepoxy(meth)acrylat.

7. Fotoresistharzzusammensetzung nach einem der Ansprüche 1 bis 6, wobei der Initiator der Fotopolymerisation mindestens eine Verbindung umfasst, die ausgewählt ist aus der Gruppe bestehend aus einer oximbasieren Verbindung, einer acetophenonbasierten Verbindung, einer thioxanthonbasierten Verbindung und einer benzophenonbasierten Verbindung.

8. Fotoresistharzzusammensetzung nach einem der Ansprüche 1 bis 7, wobei das Bindeharz mindestens ein Harz umfasst, das ausgewählt ist aus der Gruppe bestehend aus einem Epoxidharz und einem Acrylharz.

9. Fotoresistharzzusammensetzung nach einem der Ansprüche 1 bis 8, wobei das Lösemittel mindestens eine Verbindung umfasst, die ausgewählt ist aus der Gruppe bestehend aus Ethylenglycolmonoethylether, Ethylcellosolvacetat, 2-Hydroxyethylpropionat, Diethylenglycolmonomethylether, Propylencglycolmonomethyletheracetat und Propylenglycolpropyletheracetat.

10. Folie, hergestellt durch Durchführen einer Wärmebehandlung an der Fotoresistharzzusammensetzung nach einem der Ansprüche 1 bis 9.

11. Farbumwandlungselement, die Folie nach Anspruch 10 umfassend.

12. Elektronische Vorrichtung, das Farbumwandlungselement nach Anspruch 11 und eine Anzeigevorrichtung umfassend.

13. Elektronische Vorrichtung nach Anspruch 12, wobei die Anzeigevorrichtung eine Flüssigkristallanzeigevorrichtung, eine organische lichtemittierende Vorrichtung oder eine anorganische lichtemittierende Vorrichtung umfasst.

14. Elektronische Vorrichtung nach Anspruch 13, wobei:
die Anzeigevorrichtung die Flüssigkristallanzeigevorrichtung umfasst und die Flüssigkristallanzeigevorrichtung eine Lichtquelle umfasst, die dafür konfiguriert ist, blaues Licht zu emittieren, oder
die Anzeigevorrichtung die organische lichtemittierende Vorrichtung umfasst, die ein organisches lichtemittierendes Bauelement umfasst, und
wobei die organische lichtemittierende Vorrichtung eine organische lichtemittierende Schicht umfasst, die eine organische Verbindung umfasst, die dafür konfiguriert ist, blaues Licht zu emittieren, oder
die Anzeigevorrichtung die anorganische lichtemittierende Vorrichtung umfasst, die ein anorganisches lichtemittierendes Bauelement umfasst, und wobei das anorganische lichtemittierende Bauelement eine anorganische lichtemittierende Schicht umfasst, die eine anorganische Verbindung umfasst, die dafür gestaltet ist, blaues Licht zu emittieren.

## Revendications

1. Composition de résine photosensible, comprenant :
une pluralité de points quantiques ;
un monomère photopolymérisable ;
un initiateur de photopolymérisation ;
un diffuseur ;
un liant résineux ; et
un solvant,
dans laquelle une quantité du diffuseur est dans une plage comprise entre environ 2 parties et environ 20 parties en poids sur la base de 100 parties en poids d'une quantité totale de la composition de résine photosensible ; et
**caractérisée en ce que** la composition de résine photosensible comprend les points quantiques et le diffuseur selon un rapport en poids dans une plage comprise entre 2:1 et 10:1.

2. Composition de résine photosensible selon la revendication 1, dans laquelle le diffuseur comprend une pluralité de particules inorganiques présentant des diamètres de particules différents les uns des autres ;
dans laquelle la pluralité des particules inorganiques présentent chacune un diamètre de particule supérieur à 20 nm et inférieur à 2 µm ; et/ou
dans laquelle la pluralité des particules inorganiques présentent chacune un indice de réfraction supérieur à 1,5.

3. Composition de résine photosensible selon la revendication 1 ou la revendication 2, dans laquelle le diffuseur comprend au moins un composé sélectionné dans le groupe constitué de BiFeO₃, Fe₂O₃, WO₃, TiO₂, SiC, BaTiO₃, ZnO, ZrO₂, ZrO, Ta₂O₅, MoO₃, TeO₂, Nb₂O₅, Fe₃O₄, V₂O₅, Cu₂O, BP, Al₂O₃, In₂O₃, SnO₂, Sb₂O₃, et ITO.

4. Composition de résine photosensible selon l'une quelconque des revendications 1 à 3, dans laquelle les points quantiques comprennent au moins un élément sélectionné dans le groupe constitué d'un composé des Groupes II-VI, un composé des Groupes III-V, un composé des Groupes IV-VI, un composé du Groupe IV-IV, et un élément du Groupe IV, ou un alliage correspondant, et
présentent une structure noyau-enveloppe incluant un noyau et une enveloppe recouvrant le noyau ; facultativement dans lequel le noyau comprend au moins un composé sélectionné dans le groupe constitué de CdS, CdSe, ZnS, ZnSe, ZnTe, HgS, HgSe, HgTe, CdTe, CdSeS, CdSeTe, CdZnS, CdZnSe, GaN, GaP, GaAs, GaInP, GaInN, InP, InAs, InZnP, ZnO, et un alliage correspondant, et
l'enveloppe comprend au moins un composé sélectionné dans le groupe constitué de CdS, CdSe, ZnSe, ZnS, ZnSeS, ZnTe, CdTe, CdO, ZnO, InP, GaN, GaP, GaInP, GaInN, Hgs, HgSe, et un alliage correspondant.

5. Composition de résine photosensible selon l'une quelconque des revendications 1 à 4, dans laquelle :
les points quantiques présentent un diamètre de particule moyen dans une plage comprise entre 3 nm et 20 nm ; et/ou
une quantité des points quantiques est dans une plage comprise entre 20 parties et 60 parties en poids sur la base de 100 parties en poids de la quantité totale de la composition de résine photosensible.

6. Composition de résine photosensible selon l'une quelconque des revendications 1 à 5, dans laquelle le monomère photopolymérisable comprend au moins un composé sélectionné dans le groupe constitué de di(méth)acrylate d'éthylène-glycol, de di(méth)acrylate de diéthylène glycol, de di(méth)acrylate de triéthylène glycol, de di(méth)acrylate de propylène glycol, de di(méth)acrylate de néopentyl-glycol, de di(méth)acrylate d'1,4-butanediol, de di(méth)acrylate d'1,6-hexanediol, de di(méth)acrylate de bisphénol A, de di(méth)acrylate de pentaérythritol, de tri(méth)acrylate de pentaérythritol, de tétra(méth)acrylate de pentaérythritol, d'hexa(méth)acrylate de pentaérythritol, de di(méth)acrylate de dipentaérythritol, de tri(méthyl)acrylate de dipentaérythritol, de penta(méth)acrylate de dipentaérythritol, d'hexa(méth)acrylate de dipentaérythritol, d'époxy(méth)acrylate de bisphénol A, de monométhyléther(méth)acrylate d'éthylène glycol, de tri(méth)acrylate de triméthylolpropane, de tris(méth)acryloyloxyéthyl-phosphate, et de (méth)acrylate d'époxy novolac.

7. Composition de résine photosensible selon l'une quelconque des revendications 1 à 6, dans laquelle l'initiateur de photopolymérisation comprend au moins un composé sélectionné dans le groupe constitué d'un composé à base d'oxime, d'un composé à base d'acétophénone, d'un composé à base de thioxanthone, et d'un composé à base de benzophénone.

8. Composition de résine photosensible selon l'une quelconque des revendications 1 à 7, dans laquelle le liant résineux comprend au moins une résine sélectionnée dans le groupe constitué d'une résine époxy et d'une résine acrylique.

9. Composition de résine photosensible selon l'une quelconque des revendications 1 à 8, dans laquelle le solvant comprend au moins un composé sélectionné dans le groupe constitué de monoéthyl-éther d'éthylène glycol, d'acétate d'éthylcellosolve, de propionate de 2-hydroxyéthyle, de monométhyléther de diéthylène glycol, d'acétate de monométhyléther de propylène glycol, et d'acétate de propyléther de propylène glycol.

10. Film préparé en réalisant un traitement thermique sur la composition de résine photosensible selon l'une quelconque des revendications 1 à 9.

11. Élément de conversion de couleur comprenant le film selon la revendication 10.

12. Appareil électronique comprenant l'élément de conversion de couleur selon la revendication 11 et un appareil d'affichage.

13. Appareil électronique selon la revendication 12, dans lequel l'appareil d'affichage comprend un appareil d'affichage à cristaux liquides, un appareil électroluminescent organique, ou un appareil électroluminescent inorganique.

14. Appareil électronique selon la revendication 13, dans lequel :
l'appareil d'affichage comprend l'appareil d'affichage à cristaux liquides, et l'appareil d'affichage à cristaux liquide comprend une source lumineuse configurée pour émettre une lumière bleue ; ou
l'appareil d'affichage comprend l'appareil électroluminescent organique, qui comprend un dispositif luminescent organique, et
dans lequel le dispositif luminescent organique comprend une couche luminescente organique comprenant un composé organique configuré pour émettre une lumière bleue ; ou
l'appareil d'affichage comprend l'appareil luminescent inorganique, qui comprend un dispositif luminescent inorganique, et dans lequel le dispositif luminescent inorganique comprend une couche luminescente inorganique comprenant un composé inorganique configuré pour émettre une lumière bleue.
